# EUROPÄISCHE PATENTSCHRIFT

(11) **EP 3 049 546 B1**
(45) Veröffentlichungstag und Bekanntmachung des Hinweises auf die Patenterteilung: **15.05.2019**
(21) Anmeldenummer: 14739191.6
(22) Anmeldetag: 16.07.2014
(51) Int. Cl.: C23C 14/58, C23C 14/06, C23C 14/18, C23C 14/02

(54) **VERFAHREN ZUR HERSTELLUNG DER RÜCKKONTAKTSCHICHT FÜR CDTE-DÜNNSCHICHT-SOLARZELLEN**
METHOD FOR PRODUCING THE REAR CONTACT LAYER FOR CDTE THIN-FILM SOLAR CELLS
PROCÉDÉ PERMETTANT DE PRODUIRE LA COUCHE DE CONTACT ARRIÈRE POUR DES PHOTOPILES À COUCHE MINCE EN CDTE

(30) Priorität: 26.09.2013 CN 201310446479
(43) Veröffentlichungstag der Anmeldung: 03.08.2016
(73) Patentinhaber: China Triumpf International Engineering Co. Ltd., Shanghai 200063 (CN); CTF Solar GmbH, 01099 Dresden (DE)
(72) Erfinder: SIEPCHEN, Bastian, 01099 Dresden (DE); SPÄTH, Bettina, 01099 Dresden (DE); PENG, Shou, Shanghai (CN)
(74) Vertreter: Kailuweit & Uhlemann Patentanwälte Partnerschaft mbB
(86) Internationale Anmeldenummer: PCT/EP2014/065251
(87) Internationale Veröffentlichungsnummer: WO 2015/043794

(56) Entgegenhaltungen:
- US-A1- 2012 192 948
- YAN Y ET AL: "Microstructure of CdTe thin films after mixed nitric and phosphoric acids etching and (HgTe, CuTe)-graphite pasting", THIN SOLID FILMS, ELSEVIER-SEQUOIA S.A. LAUSANNE, CH, Bd. 472, Nr. 1-2, 24. Januar 2005 (2005-01-24), Seiten 291-296, XP027864933, ISSN: 0040-6090 [gefunden am 2005-01-24]
- BATZNER D L ET AL: "A study of the back contacts on CdTe/CdS solar cells", THIN SOLID FILMS, ELSEVIER-SEQUOIA S.A. LAUSANNE, CH, Bd. 361-362, Nr. 1, 1. Februar 2000 (2000-02-01), Seiten 463-467, XP004187520, ISSN: 0040-6090, DOI: 10.1016/S0040-6090(99)00842-1
- ANKE E ABKEN: "Electrodeposition of Sb x Te y layers and chemical stability of Mo/Sb2Te3 systems", JOURNAL OF MATERIALS SCIENCE LETTERS, KLUWER ACADEMIC PUBLISHERS, BO, Bd. 21, Nr. 11, 1. Juni 2002 (2002-06-01), Seiten 845-847, XP019249112, ISSN: 1573-4811
- BAETZNER D L ET AL: "EFFECT OF BACK CONTACT METALLIZATION ON THE STABILITY OF CdTe/CdS SOLAR CELLS", 16TH. E.C. PHOTOVOLTAIC SOLAR ENERGY CONFERENCE. GLASCOW, UNITED KINGDOM, MAY 1 - 5, 2000; [PROCEEDINGS OF THE INTERNATIONAL PHOTOVOLTAIC SOLAR ENERGY CONFERENCE], LONDON : JAMES & JAMES LTD, GB, Bd. CONF. 16, 1. Mai 2000 (2000-05-01), Seiten 353-356, XP001138312, ISBN: 978-1-902916-18-7
- PROSKURYAKOV Y ET AL: "Admittance spectroscopy of CdTe/CdS solar cells subjected to varied nitric-phosphoric etching conditions", JOURNAL OF APPLIED PHYSICS, AMERICAN INSTITUTE OF PHYSICS, US, Bd. 101, Nr. 1, 9. Januar 2007 (2007-01-09), Seiten 14505-014505, XP012096813, ISSN: 0021-8979, DOI: 10.1063/1.2402961

## Beschreibung

Gegenstand der vorliegenden Erfindung ist ein Verfahren zur verbesserten Ausführung der Rückkontaktschicht, genauer der Rückkontaktschichtfolge für CdTe-Dünnschicht-Solarzellen.

CdTe-Dünnschicht Solarzellen in Superstrat-Konfiguration werden nach dem Stand der Technik hergestellt, indem auf ein Substrat (vorzugsweise Glas) eine transparente Frontkontaktschicht (TCO - transparent conductive oxide) aufgebracht wird. Auf dieser wird eine Schicht Cadmiumsulfid (CdS) abgeschieden und darüber eine Schicht Cadmiumtellurid (CdTe) aufgebracht. Auf die CdTe-Schicht wird wiederum die Rückkontaktschicht, bzw. die Rückkontaktschichtfolge abgeschieden.

Problematisch dabei ist, dass es nicht ohne weiteres möglich ist, auf das CdTe eine metallische Kontaktschicht aufzutragen, da dies zum Entstehen eines gleichrichtenden Schottky-Kontaktes führen würde. Gewünscht ist jedoch das Entstehen eines ohmschen Kontaktes. Aufgabe der Schichtfolge ist es, die Angleichung der Energieniveaus der einzelnen Schichtenmaterialien so zu realisieren, dass ein ohmscher Kontakt entsteht, wobei als oberste Rückkontaktschicht eine metallische Schicht bevorzugt ist.

Während des Herstellungsprozesses erfolgt nach dem Aufbringen des CdTe bevorzugt eine Aktivierung des CdTe mittels CdCl₂ und Erhitzung.

Verfahren aus dem Stand der Technik sehen vor, die Cadmiumtelluridschicht anschließend einer nasschemischen Ätzung zu unterziehen. Dazu wird die CdTe-Solarzelle in eine sogenannte NP-Ätze eingetaucht. Die NP-Ätze ist eine wässrige Lösung verschiedener anorganischer Säuren, bevorzugt (HNO₃ (0,5% - 5%)/ H₃PO₄ (50% - 85%)/ H₂O(15% - 45%) (Summe 100%). Dies erfolgt im Temperaturbereich von Raumtemperatur (18°C bis ca. 80°C). Die Ätzzeit liegt bevorzugt im Bereich von 5 s bis 60 s. Im Ergebnis der NP-Ätze entsteht eine Te-reiche Schicht, deren Dicke im Bereich von 1 nm bis 300 nm liegt.

Alternativ wird Brommethanol als Ätzmittel eingesetzt. Die Konzentration liegt dabei bevorzugt im Bereich von 0.1 - 5% Br₂, besonders bevorzugt im Bereich von 0.5 - 1%. Während des Ätzvorganges (Ätzzeit 3 s bis 30 s) wird bevorzugt eine Temperatur von vorzugsweise 15°C bis 50°C, besonders bevorzugt von 20°C bis 35°C und ganz besonders bevorzugt von 21 °C bis 30°C eingehalten. Die erreichte Dicke der Te-reichen Schicht liegt im Bereich von 1 nm bis 30 nm.

Der Ätzschritt reinigt die Oberfläche unter anderem von Oxiden, die im Prozessverlauf der Herstellung bei Atmosphärenkontakt auf dieser entstanden sind. Hierzu können optional zusätzliche Behandlungen mit reduzierenden Lösungen notwendig sein, um die Oxide möglichst vollständig aus der Te-Schicht zu entfernen.

Anschließend wird bei Verfahren nach dem Stand der Technik häufig eine Sb₂Te₃-Schicht aufgebracht, vorzugsweise durch das Aufsputtern von Sb₂Te₃. Anschließend werden weitere Lagen der Rückkontaktschichtfolge, typischerweise aus Molybdän und Nickel, aufgebracht. Ein entsprechendes Verfahren ist bspw. in der US 7,211,462 B1 beschrieben, wobei auf einen Ätzschritt verzichtet wird und lediglich eine CdCl₂ -Behandlung der Oberfläche erfolgt. Die Sb₂Te₃-Schicht wird hier durch Sputtern aufgebracht. Andere bekannte Methoden zum Aufbringen der Sb₂Te₃-Schicht sehen Verdampfen, oder eine elektrolytische Abscheidung vor. Bei Bedarf können auch mehrere Sb₂Te₃-Schichten vorgesehen sein.

Die Abscheidung der Sb₂Te₃-Schicht ist sehr kostenintensiv, da Sb₂Te₃ sehr teuer ist.

Das Patentdokument US 2012/192948 A1 offenbart die Abscheidung von Te als Rückseitenkontakt.

YAN Y ET AL. in "Microstructure of CdTe thin films after mixed nitric and phosphoric acids etching and (HgTe, CuTe)-graphite pasting",THIN SOLID FILMS, ELSEVIER-SEQUOIA S.A. LAUSANNE, CH, Bd. 472, Nr. 1-2, 24. Januar 2005 (2005-01-24), Seiten 291-296 offenbaren die Abscheidung von HgTe Schichten.

BATZNER D L ET AL in "A study of the back contacts on CdTe/CdS solar cells",THIN SOLID FILMS, ELSEVIER-SEQUOIA S.A. LAUSANNE, CH, Bd. 361-362, Nr. 1, 1. Februar 2000 (2000-02-01), Seiten 463-467, offenbaren die Abscheidung von Sb/Au Schichten.

ANKE E ABKEN in "Electrodeposition of Sb x Te y layers and chemical stability of Mo/Sb2Te3 systems",JOURNAL OF MATERIALS SCIENCE LETTERS, KLUWER ACADEMIC PUBLISHERS, BO, Bd. 21, Nr. 11, 1. Juni 2002 (2002-06-01), Seiten 845-847, offenbaren die Abscheidung von SbTe.

Es stellt sich somit die Aufgabe, die Sb₂Te₃-Schicht auf alternative Weise zu erzeugen oder durch andere Materialien zu ersetzen.

Erfindungsgemäß wird die Aufgabenstellung mit dem Verfahren nach Anspruch 1 gelöst. Vorteilhafte Ausführungsformen sind in den rückbezogenen Unteransprüchen offenbart. Erfindungsgemäß wird die Aufgabe gelöst, indem eine erste Rückkontaktschicht, wie bspw. die Sb₂Te₃-Schicht, nicht mehr durch das direkte Aufbringen der ersten Rückkontaktschicht hergestellt wird, sondern aus deren Bestandteilen erzeugt wird, wobei eine Tellur-reiche Oberflächenschicht der CdTe-Schicht genutzt wird.

Untersuchungen haben gezeigt, dass im Verlauf der Aktivierung des CdTe mit CdCl₂ Oxide an der Oberfläche entstehen. Der nachfolgende Ätzschritt sowie weitere optionale Behandlungen führen zur Entfernung der oberflächlichen Oxide und zum Herauslösen des Cadmiums aus der CdTe-Schicht. Zurück bleibt eine besonders Tellur-reiche Oberflächenschicht der CdTe-Schicht.

Diese bereits mit Tellur angereicherte Oberflächenschicht hat eine Dicke von bevorzugt 1 nm bis 300 nm, besonders bevorzugt von 10 nm bis 150 nm. Die erste Rückkontaktschicht wird nunmehr hergestellt, indem dieser Oberflächenschicht ein erstes Material, z.B. Antimon, zugeführt wird, so dass sich die angestrebte Schicht aus dem zweiten Material, z.B. die Sb₂Te₃-Schicht, herausbilden kann.

Auch andere Materialien, die mit Tellur eine elektrisch leitfähige Verbindung - also das zweite Material - bilden, können statt Antimon als erstes Material verwendet werden. Dies sind bevorzugt Zink (Zn), Arsen (As) oder Quecksilber (Hg).

Die Zuführung des ersten Materials erfolgt mit für das jeweilige erste Material geeigneten Verfahren nach dem Stand der Technik. So sind bspw. Sputtern und Verdampfen besonders geeignete Vorgehensweisen. Ebenfalls geeignet ist elektrochemisches oder nasschemisches Abscheiden. Als weiterhin geeignet sind Verfahren ähnlich zu dem Verfahren nach US 5,124,278 anzusehen, bei dem die Zuführung des ersten Materials mit speziellen CVD (Chemical Vapour Deposition) Methoden, also MOCVD (*metallo-organic chemical vapour deposition*), oder OMVPE (organometallic vapour phase epitaxy) erfolgt. Ausgangsstoffe sind hier metallorganische Verbindungen. Auch die thermische Zersetzung einer metallorganischen Verbindung auf der Te-reichen Oberfläche ist möglich.

Beim Aufbringen des ersten Materials auf die Te-reiche Oberflächenschicht bildet sich, insbesondere bei den trockenen Verfahren, eine Schicht aus dem ersten Material aus. Zur anschließenden Ausbildung der ersten Rückkontaktschicht kann daher in Abhängigkeit von dem gewählten Verfahren ein Temperaturbehandlungsschritt notwendig sein. Die anschließende Temperaturbehandlung im Vakuum liegt bevorzugt im Temperaturbereich von 50°C - 300°C für 1 min - 30 min und besonders bevorzugt im Bereich von 130°C - 170°C für 8 min - 10 min. Erfahrungen haben ein Optimum von ca. 150°C für ca. 10 min gezeigt. Dies kann jedoch in Abhängigkeit vom ersten Material, vom angewandten Verfahren zum Aufbringen des ersten Materials und anderen Prozessparametern abweichen.

Vorzugsweise kommen zum Aufbringen des ersten Materials die folgenden Verfahren zum Einsatz:
- Sputtern: Substrattemperatur 20°C-300°C, erreichte Schichtdicke 10 nm - 150 nm
- Verdampfen: Substrattemperatur 20°C-300°C, erreichte Schichtdicke 10 nm - 150 nm
- Nasschemisch: Substrattemperatur 20°C-100°C, erreichte Schichtdicke 10 nm - 150 nm
- MOCVD oder OMVPE aus metallorganischen Verbindungen ähnlich zu US 5,124,278
- Zersetzung von metallorganischen Verbindungen auf der Te-reichen Schicht bei 520°C bis 550°C, erreichte Schichtdicke 10 nm - 150 nm

Bevorzugt liegen die Einzelschichtdicken in den folgenden Bereichen: Te 20 nm - 150 nm, erstes Material 10 nm - 150 nm, besonders bevorzugt: Te 40 nm - 100 nm, erstes Material 20 nm - 100 nm, und ganz besonders bevorzugt: Te 55 nm - 60 nm, erstes Material 40 nm - 60 nm. Dabei korrespondieren die Einzelschichtdicken zu dem im zweiten Material einzustellenden stöchiometrischen Verhältnis des ersten Materials zu Te. Dies ist für Zinktellurid (ZnTe) und Quecksilbertellurid (HgTe) vorzugsweise ein Verhältnis von 1:1, während es für Arsentellurid (As₂Te₃) und Antimontellurid (Sb₂Te₃) vorzugsweise ein Verhältnis von 2:3 ist.

Nach dem Herstellen der ersten Rückkontaktschicht werden die weiteren Schichten der Rückkontaktschichtfolge entsprechend zum Stand der Technik aufgebracht. Bevorzugt sind hier Molybdän und Ni:V-Schichten, die bspw. aufgesputtert werden können.

Das erfindungsgemäße Verfahren stellt somit die erste Rückkontaktschicht als Basisschicht des Rückkontaktschichtstapels aus dem ersten Material und Te her, ohne dass das teure zweite Material, z.B. Sb₂Te₃, als Verbindung zur Verfügung gestellt werden muss.

### Figuren

Die Figuren Fig.1 bis Fig. 5 zeigen schematisch die Abfolge der erfindungsgemäßen Prozessschritte für ein erstes Ausführungsbeispiel, bei dem eine Sb₂Te₃-Schicht als erste Rückkontaktschicht erzeugt wird.
**Fig. 1** zeigt die vorbereitete Solarzelle mit dem Substrat (1), auf das der transparente Frontkontakt (21) sowie die CdS-Schicht (3) und darüber die CdTe-Schicht (4) bereits aufgebracht sind.
In **Fig. 2** wird schematisch der Ätzprozess mittels NP-Ätze (6) dargestellt.
   Nach dem Ätzprozess verbleibt, wie in **Fig. 3** schematisch dargestellt, eine Te-reiche Schicht (41), aus der das Cd überwiegend herausgelöst ist.
**Fig. 4** zeigt schematisch, dass über der Te-reichen Schicht (41) eine Sb-Schicht angeordnet wird.
Wie in **Fig. 5** schematisch dargestellt, reagieren die Te-reiche Schicht (41) und die Sb-Schicht (7) unter Temperatureinwirkung zu einer Sb₂Te₃-Schicht (5).

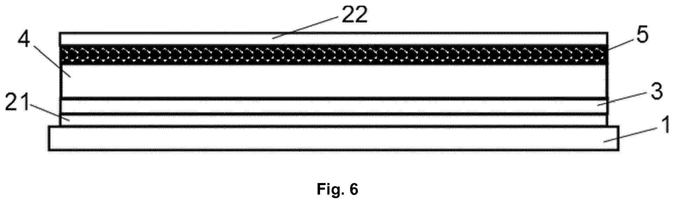

**Fig. 6** zeigt schematisch die Schichtfolge der fertigen Solarzelle nach dem Aufbringen des Rückkontaktes (22) auf die Sb₂Te₃-Schicht (5). Die Rückkontaktschicht (22) kann dabei als Schichtfolge ausgebildet sein.

### Ausführungsbeispiele

Im Folgenden wird der erfindungsgemäße Prozess an Hand zweier Ausführungsbeispiele erläutert, ohne diesen auf diese Beispiele zu beschränken.

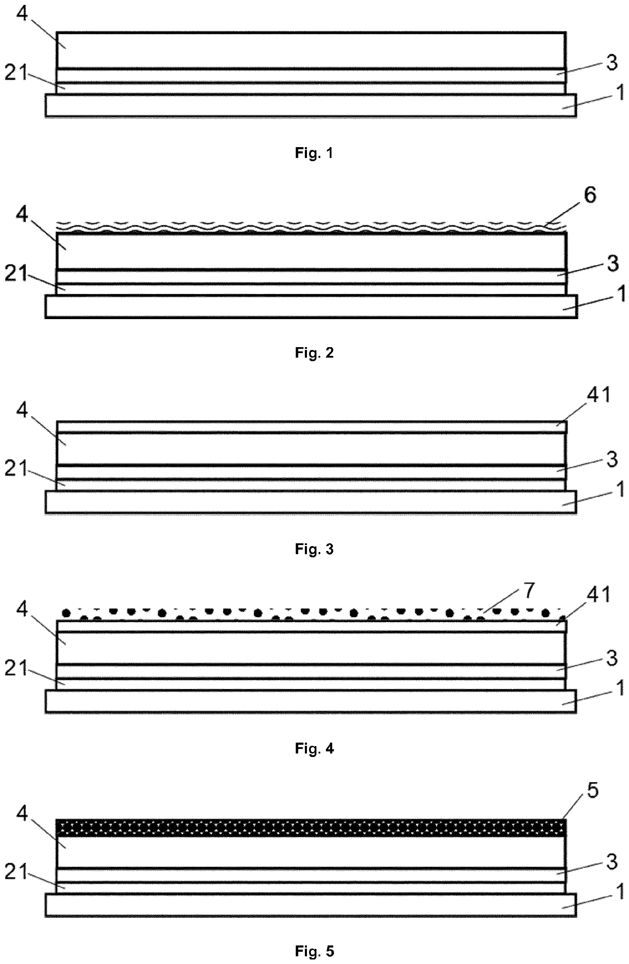

Gemäß eines ersten Ausführungsbeispiels wird nach dem Aufbringen der Frontkontaktschicht (21), der CdS-Schicht (3) und der CdTe-Schicht (4) auf das Glassubstrat (1) (Fig. 1) die CdTe-Oberflächenschicht nach dem Stand der Technik mit CdCl₂ bei 400°C aktiviert. Anschließend erfolgt der NP-Ätzschritt (Fig. 2) mit einer NP Ätzlösung (6): (HNO₃ (1%)/ H₃PO₄ (77%)/ H₂O (22%) bei einer Temperatur von 20°C. Es bildet sich eine Te-reiche Schicht (41) mit einer Schichtdicke von 150 nm heraus (Fig. 3). Das Cadmium ist in dieser Schicht nur noch stark unterstöchiometrisch enthalten.

Anschließend wird bei einer Substrattemperatur von 150°C eine Sb-Schicht (7) von 45 nm auf die Te-reiche Schicht (41) aufgesputtert (Fig. 4).

Anschließend wird die gesamte Schichtfolge für einen Zeitraum von 12 min bei 150°C im Vakuum nachgeheizt, um die Ausbildung der Sb₂Te₃-Verbindung (5) hervorzurufen. Die resultierende Schichtdicke des Sb₂Te₃ beträgt 90 nm (Fig. 5).

Nachfolgend erfolgt die Abscheidung der Rückkontaktschicht (22), die aus einer Schichtfolge von Molybdänschicht und Nickelschicht mit Vanadiumzusatz besteht. Die Molybdänschicht (150 nm) wird mittels Sputterns auf der Sb₂Te₃-Schicht abgeschieden. Abschließend wird noch eine Nickelschicht mit Vanadiumzusatz auf der Molybdänschicht abgeschieden (Sputtern, 150 nm).

Alternativ wird in einem zweiten Ausführungsbeispiel anschließend an das Erzeugen der Te-reichen Schicht (41) durch das Aufsputtern einer 35 nm dicken Zn-Schicht auf die Te-reiche Schicht (41) anstelle der Sb-Schicht (7) und eine darauf folgende Temperaturbehandlung mit den gleichen Parametern, wie im ersten Ausführungsbeispiel beschrieben, eine 70 nm dicke ZnTe-Schicht anstelle der Sb₂Te₃-Schicht (5) erzeugt. Nachfolgend wird die Rückkontaktschicht (22), wie im ersten Ausführungsbeispiel beschrieben, abgeschieden.

### Bezugszeichen

- 1: Substrat (Glas)
- 21: Frontkontakt (transparent, TCO)
- 22: Rückkontakt (Metall)
- 3: CdS-Schicht
- 4: CdTe-Schicht
- 41: Te-reiche Schicht nach dem Ätzen
- 5: Sb₂Te₃-Schicht
- 6: NP-Ätze
- 7: Aufgesputterte Sb-Schicht

## Patentansprüche

1. Verfahren zur Herstellung einer Rückkontaktschicht für CdTe-Dünnschicht-Solarzellen in Superstrat-Konfiguration, **dadurch gekennzeichnet, dass** eine erste Rückkontaktschicht mit den Schritten
- Erzeugen einer Tellur-reichen Oberflächenschicht der Cadmiumtellurid-Schicht,
- Abscheiden einer Schicht aus einem elementarem ersten Material aus der Gruppe umfassend Antimon, Arsen oder Quecksilber auf der Tellur-reichen Oberflächenschicht und
- Erzeugen der ersten Rückkontaktschicht durch die Reaktion des ersten Materials und Tellur in der Oberflächenschicht, wobei das Substrat für einen Zeitraum von 1 min bis 30 min auf eine Temperatur zwischen 50°C und 300°C erwärmt wird,
erzeugt wird.

2. Verfahren nach Anspruch 1, **dadurch gekennzeichnet, dass** die Tellur-reiche Oberflächenschicht durch einen NP-Ätzschritt oder einen Brom/Methanol Ätzschritt erzeugt wird.

3. Verfahren nach Anspruch 2, **dadurch gekennzeichnet, dass** die Entstehung einer Tellur-reichen Oberflächenschicht durch Erwärmen des Substrats beim Ätzschritt unterstützt wird.

4. Verfahren nach einem der vorhergehenden Ansprüche, **dadurch gekennzeichnet, dass** das erste Material auf die Tellur-reiche Oberflächenschicht durch Sputtern, Verdampfen, elektrochemisches oder nasschemisches Abscheiden oder CVD-Verfahren aufgebracht wird.

## Claims

1. A method for the manufacture of a back contact layer for CdTe thin-layer solar cells in superstrate configuration, **characterized in that** a first back contact layer is produced by means of the following steps:
- producing a tellurium-rich surface layer of the cadmium telluride layer,
- depositing a layer of an elemental first material of the group comprising antimony, arsenic or mercury on the tellurium-rich surface layer, and
- producing the first back contact layer by reacting the first material and tellurium in the surface layer, wherein the substrate is heated to a temperature between 50°C and 300°C for a time period of 1 min to 30 min.

2. The method as claimed in claim 1, **characterized in that** the tellurium-rich surface layer is produced by means of a NP etch step or a bromomethanol etching step.

3. The method as claimed in claim 2, **characterized in that** the formation of a tellurium-rich surface layer is promoted by heating the substrate during the etching step.

4. The method as claimed in one of the preceding claims, **characterized in that** the first material is applied to the tellurium-rich surface layer by sputtering, vapour deposition, electrochemical or wet chemical deposition, or by a CVD method.

## Revendications

1. Procédé de fabrication d'une couche de contact arrière pour cellules solaires à couche mince de CdTe en configuration superstrate, dans lequelune première couche de contact arrière est créée par les étapes suivantes :
- Production d'une couche superficielle riche en tellure de la couche de tellurure de cadmium,
- Dépôt d'une couche d'un premier matériau élémentaire choisi dans le groupe constitué par l'antimoine, l'arsenic ou le mercure sur la couche superficielle riche en tellure ; et
- Production de la première couche de contact arrière par réaction du premier matériau et du tellure dans la couche superficielle, dans laquelle le substrat est chauffé à une température comprise entre 50 °C et 300 °C pendant une durée de 1 min à 30 min.

2. Procédé selon la revendication 1, dans lequel la couche superficielle riche en tellure est produite par une étape de gravure NP ou une étape de gravure au brome/méthanol.

3. Procédé selon la revendication 2, dans lequel la formation d'une couche superficielle riche en tellure est soutenue par chauffage du substrat pendant l'étape de gravure.

4. Procédé selon l'une des revendications précédentes, dans lequel le premier matériau est appliqué sur la couche superficielle riche en tellure par pulvérisation cathodique, évaporation, dépôt électrochimique ou chimique en phase liquide ou procédé CVD.
